# EUROPÄISCHE PATENTSCHRIFT

(11) **EP 3 462 189 B1**
(45) Veröffentlichungstag und Bekanntmachung des Hinweises auf die Patenterteilung: **01.04.2020**
(21) Anmeldenummer: 18191908.5
(22) Anmeldetag: 31.08.2018
(51) Int. Cl.: G01R 27/02, G01R 27/26, G01R 31/02

(54) **VERFAHREN UND ÜBERWACHUNGSVORRICHTUNG ZUR SELEKTIVEN BESTIMMUNG EINER TEIL-NETZABLEITKAPAZITÄT IN EINEM UNGEERDETEN STROMVERSORGUNGSSYSTEM**
METHOD AND MONITORING DEVICE FOR SELECTIVE DETERMINATION OF A SUB-NET DISCHARGE CAPACITY IN AN UNEARTHED POWER SUPPLY SYSTEM
PROCÉDÉ ET DISPOSITIF DE SURVEILLANCE DESTINÉS À LA DÉTERMINATION SÉLECTIVE D'UNE CAPACITÉ PARTIELLE DE DÉRIVATION DU RÉSEAU DANS UN SYSTÈME D'ALIMENTATION ÉLECTRIQUE NON MIS À LA MASSE

(30) Priorität: 29.09.2017 DE 102017217473
(43) Veröffentlichungstag der Anmeldung: 03.04.2019
(73) Patentinhaber: Bender GmbH & Co. KG, 35305 Grünberg (DE)
(72) Erfinder: HACKL, Dieter, 35463 Fernwald (DE); LEHR, Mario, 35305 Grünberg (DE)
(74) Vertreter: advotec.

(56) Entgegenhaltungen:
- DE-A1-102011 050 590
- DE-B3-102014 201 044

## Beschreibung

Die Erfindung betrifft ein Verfahren und eine Überwachungsvorrichtung zur selektiven Bestimmung einer Teil-Netzableitkapazität in einem ungeerdeten Stromversorgungssystem, welches aus einem Hauptsystem und mindestens einem Teilsystem besteht.

Bei erhöhten Anforderungen an die Betriebs-, Brand und Berührungssicherheit kommt die Netzform eines ungeerdeten Stromversorgungssystems zum Einsatz. Bei dieser Netzform sind die aktiven Teile des Stromversorgungssystems von dem Erdpotenzial - gegenüber "Erde" - getrennt oder über eine ausreichend hohe Impedanz mit dem Erdpotenzial verbunden. Ein Stromversorgungssystem in dieser Form daher auch als isoliertes Netz (frz. Isolé Terre - IT) oder als IT-Stromversorgungssystem bezeichnet.

Als ausreichend hoch wird eine (Neutralpunkt-/Sternpunkt-)Impedanz zwischen den aktiven Teilen und Erde dann angesehen, wenn im ersten Fehlerfall, wie beispielsweise einem Erdschluss oder einem Körperschluss, keine gefährlichen Fehlerströme entstehen können.

Der wesentliche Vorteil des ungeerdeten Stromversorgungssystems besteht darin, dass das ungeerdete Stromversorgungssystem unter der Voraussetzung, dass der Isolationszustand kontinuierlich von einem Isolationsüberwachungssystem überwacht wird, auch bei einem aufgetretenen ersten Fehler ohne vorgeschriebene Zeitlimitierung weiterbetrieben werden kann, jedoch gilt die Empfehlung, den ersten Fehler so schnell wie praktisch möglich zu beseitigen.

Um die Anforderung nach der schnellen Beseitigung des ersten Fehlers zu erfüllen, wird in ausgedehnten, weit verzweigten ungeerdeten Stromversorgungssystemen mit einem Hauptsystem und mit mehreren Teilsystemen üblicherweise ein Isolationsfehlersuchsystem eingesetzt.

Das Isolationsfehlersuchsystem besteht im Wesentlichen aus einem Prüfstrom-Generator, der einen Prüfstrom erzeugt und diesen an zentraler Stelle in das ungeerdete Stromversorgungssystem zwischen einem oder mehreren aktiven Leitern und Erde einspeist sowie aus mehreren meist als Messstromwandler ausgeführten Prüfstrom-Sensoren, die an den zu überwachenden Leitungsabgängen (Teilsystemen) angeordnet sind, um dort einen Teil-Prüfstrom zu erfassen und die zur Auswertung der Messsignale mit einem zentralen Isolationsfehler-Auswertegerät verbunden sind.

Zur Beurteilung, ob tatsächlich ein nicht geerdetes oder ein ausreichend hochohmig geerdetes Stromversorgungssystem vorliegt, gehört neben der ständigen Überwachung des Isolationswiderstands die kritische Betrachtung der zu erwartenden Netzableitkapazitäten und der Auslegung des Erdungssystems zur Erdung angeschlossener Betriebsmittel.

Aus der Offenlegungsschrift DE 10 2011 050 590 A1 ist eine Isolations-überwachung mit einem Prüfsignal variabler Frequenz bekannt. Dabei kann die Frequenz des Prüfsignals an die aktuell wirksamen Ableitkapazitäten angepasst werden, um die Reaktionszeit bei einem Isolationsfehler möglichst kurz zu halten.

In den allermeisten Anwendungen reicht die Betrachtung der zu erwartenden Netzableitkapazitäten und des Erdungssystems in der Planungsphase, bei der Erstinbetriebnahme und bei den Wiederholungsprüfungen aus.

Es gibt jedoch sicherheitskritische elektrische Anlagen, z. B. bei Bahnanwendungen, bei denen Netzableitkapazitäten nicht als statische Größen angesehen werden können, sondern als dynamischer Parameter betrachtet werden müssen, die sich durch verschiedene Einflussfaktoren, wie z. B. Umwelteinflüsse (Feuchtigkeit, Beschädigungen), auch innerhalb der Prüfintervalle kritisch verändern können.

Eine Überschreitung eines Netzableitkapazitäts-Grenzwertes kann im Zusammenwirken mit den elektrischen Eigenschaften des vorhandenen Erdungssystems dazu führen, dass normative Anforderungen an die elektrische Sicherheit nicht mehr erfüllt werden. In diesen Fällen müsste eine automatische Abschaltung des ungeerdeten Stromversorgungssystems erfolgen.

Dies jedoch widerspricht der zugrundeliegenden Idee des ungeerdeten Stromversorgungssystems, die darin besteht, bei einem ersten Fehler eine Abschaltung der Anlage mit den Folgen eines Betriebsstillstands zu vermeiden.

Dem Stand der Technik gemäß ist man daher bestrebt, im Verlauf der Wiederholungsprüfung festzustellen, ob ein Schutzerdungssystem noch geeignet ausgelegt ist. Beispielsweise können betriebsmäßig erhöhte Netzableitkapazitäten dazu führen, dass das Schutzerdungssystem nicht mehr den Betriebsbedingungen entspricht.

Dieser Teil der Wiederholungsprüfung kann in nachteiliger Weise nicht im laufenden Betrieb der elektrischen Anlage durchgeführt werden. Je nach Ausdehnung und Komplexität des zu überprüfenden Stromversorgungssystems ist dabei mit einem erheblichen Zeitbedarf und einer entsprechenden Dauer des Betriebsstillstands zu rechnen.

Treten erhöhte Netzableitkapazitäten zudem nur in bestimmten Betriebszuständen auf, so ist die Entdeckungswahrscheinlichkeit dieser potentiellen Gefährdung während der Wiederholungsprüfung äußerst gering. Eine weitere praktizierte Lösungsmöglichkeit besteht in der Überdimensionierung des Erdungssystems. Der Schutzleiterquerschnitt wird hier von vornherein so weit überdimensioniert, dass auch bei betriebsmäßig zu erwartenden Schwankungen der Netzableitkapazitäten die normativen Anforderungen erfüllt werden. Diese Möglichkeit ist je nach Anwendungsfall nicht wirtschaftlich umsetzbar. Problematisch ist erfahrungsgemäß, dass weder der Planer noch der Betreiber der elektrischen Anlage wichtige relevante Systemparameter, wie z. B. die Netzableitkapazität und deren Schwankungsbreite, hinreichend genau kennen.

Der vorliegenden Erfindung liegt somit die Aufgabe zu Grunde, eine Lösung aufzuzeigen, mit der eine sicherheitskritische Veränderung einer Netzableitkapazität eines ungeerdeten Stromversorgungssystems erfasst werden kann, ohne dass eine mit einem Betriebsstillstand verbundene Abschaltung des gesamten ungeerdeten Stromversorgungssystems erforderlich ist.

Diese Aufgabe wird gelöst durch ein Verfahren gemäß Anspruch 1, welches die folgenden Verfahrensschritte umfasst: Bestimmen eines Gesamt-Isolationswiderstands des Stromversorgungssystems, Bestimmen einer Gesamt-Netzableitkapazität des Stromversorgungssystems, kontinuierliches Erzeugen und Einspeisen eines Prüfstroms in das Hauptsystem, Erfassen eines Teil-Prüfstroms in jedem zu überwachenden Teilsystem, Bestimmen eines ohmschen und eines kapazitiven Teil-Prüfstromanteils für jeden erfassten Teil-Prüfstrom, Bestimmen eines Teil-Isolationswiderstands und einer Teil-Netzableitkapazität für jedes zu überwachende Teilsystem aus dem Gesamt-Isolationswiderstand, aus der Gesamt-Netzableitkapazität, aus dem Prüfstrom und aus den ohmschen und kapazitiven Teil-Prüfstromanteilen, Bewerten des jeweils ermittelten Teil-Isolationswiderstands im Hinblick auf eine Unterschreitung eines Teil-Isolationswiderstands-Grenzwertes und Bewerten der jeweils ermittelten Teil-Netzableitkapazität im Hinblick auf eine Überschreitung eines Teil-Netzableitkapazitäts-Grenzwertes.

Der Grundgedanke der vorliegenden Erfindung beruht im Hinblick auf die Vermeidung einer Abschaltung des gesamten ungeerdeten Stromversorgungssystems in vorteilhafterweise darauf, zu ermitteln, in welchem Teilsystem eine kritische Erhöhung einer Teil-Netzableitkapazität stattgefunden hat.

Dazu werden mittels eines erweiterten Isolationsüberwachungssystems ein Gesamt-Isolationswiderstand und eine Gesamt-Netzableitkapazität des Stromversorgungssystems während des Betriebs kontinuierlich bestimmt. Neben der eigentlichen Aufgabe der Isolationswiderstands-Überwachung wird in dem erweiterten Isolationsüberwachungssystem zusätzlich eine Gesamt-Netzableitkapazität des Stromversorgungssystems ermittelt. Diese Gesamt-Netzableitkapazität wird in einem folgenden Verfahrensschritt (siehe unten) für die Berechnung einer für ein bestimmtes Teilsystem geltenden Teil-Netzableitkapazität herangezogen.

Gleichzeitig erzeugt ein Prüfstrom-Generator kontinuierlich einen Prüfstrom und speist diesen an zentraler Stelle zwischen einem oder mehreren aktiven Leitern und Erde in das ungeerdete Stromversorgungssystem ein.

Mittels Prüfstrom-Sensoren, die vorzugsweise als Messstromwandler ausgeführt sind, wird in jedem zu überwachenden Teilsystem ein Teil-Prüfstrom erfasst.

In Ergänzung einer bekannten Isolationsfehlersucheinrichtung ist das erweiterte Isolationsfehlersuchsystem - neben der üblichen Bestimmung eines ohmschen Teil-Prüfstromanteils - erfindungsgemäß zur Bestimmung eines kapazitiven Teil-Prüfstromanteils für jeden erfassten Teil-Prüfstrom ausgelegt.

Auf diese Weise wird somit kontinuierlich für jedes zu überwachende Teilsystem der aufgrund des zentral eingespeisten Prüfstroms in diesem Teilsystem fließende Teil-Prüfstrom erfasst und daraus der ohmsche Teil-Prüfstromanteil und der kapazitive Teil-Prüfstromanteil bestimmt.

In einem Impedanz-Auswertesystem, das eine Impedanz-Auswerteeinheit und eine Impedanz-Bewertungseinheit umfasst, erfolgt in einem nachfolgenden Schritt eine Auswertung und Bewertung der Größen Gesamt-Isolationswiderstand, Gesamt-Netzableitkapazität, Prüfstrom sowie ohmscher und kapazitiver Teil-Prüfstromanteil, um einen für das jeweilige Teilsystem geltenden Teil-Isolationswiderstand und eine geltende Teil-Netzableitkapazität zu bestimmen.

Dazu werden auf Basis der Signalform des eingespeisten Prüfstroms und dessen zugehörigen Parameter wie Amplitude, Frequenz und Phase (bei sinusförmigem Prüfstrom) oder Impulsdauer (bei impulsförmigem, rechteckförmigem Prüfstrom) und aus dem Gesamt-Isolationswiderstand (Realteil einer komplexwertigen Gesamt-Netzableitimpedanz) und aus der Gesamt-Netzableitkapazität (Imaginärteil der komplexwertigen Gesamt-Netzableitimpedanz) sowie den aus dem erfassten Teil-Prüfstrom bestimmten ohmschen und kapazitiven Teil-Prüfstromanteilen unter Anwendung des ohmschen Gesetzes und den in linearen Netzen geltenden Strom-Spannungsbeziehungen (Stromteilerregel) für jedes zu überwachende Teilsystem der Teil-Isolationswiderstand und die Teil-Netzableitkapazität ermittelt.

In der Impedanz-Bewertungseinheit erfolgt anschließend eine Bewertung des ermittelten Teil-Isolationswiderstands im Hinblick auf eine Unterschreitung eines Teil-Isolationswiderstands-Grenzwertes und eine Bewertung der ermittelten Teil-Netzableitkapazität im Hinblick auf eine Überschreitung eines Teil-Netzableitkapazitäts-Grenzwertes. Das Erkennen von Unter-/Überschreitungen ist mit der Ausgabe einer Alarmmeldung für das/die betreffenden Teilsystem(e) verbunden.

Diese Vorgehensweise stellt einen zeitlich lückenlos überwachten Betrieb des ungeerdeten Stromversorgungssystems im Hinblick auf die kritische Änderung sicherheitsrelevanter elektrischer Parameter, insbesondere den Isolationswiderstand und die Netzableitkapazität, sicher.

Das erfindungsgemäße Verfahren ermöglicht eine selektive, an jedes Teilsystem angepasste, vorausschauende und daher planbare prädiktive Wartung des ungeerdeten Stromversorgungssystems.

Es lassen sich bereits während des Betriebs der elektrischen Anlage die Kabelabschnitte (Teilsysteme) mit einer kritischen Erhöhung der Teil-Netzableitkapazität bestimmen und somit die dringend wartungsbedürftigen Teilsysteme den zur Verfügung stehenden, meist begrenzten, Instandhaltungsbudgets zuweisen.

Ohne Anwendung des erfindungsgemäßen Verfahrens müsste bei einer (lediglich zeitlich punktuell) festgestellten kritischen Gesamtableitkapazität die gesamte elektrische Anlage außer Betrieb genommen, sämtliche Teilsysteme abgetrennt und separat vermessen werden. Ein solches Vorgehen ist zum einen sehr kosten- und zeitintensiv und zum anderen in den Anwendungsfällen nicht durchführbar, die eine 100-prozentige Verfügbarkeit erfordern.

Zudem stellt das erfindungsgemäße Verfahren die technischen Voraussetzung für eine selektive Abschaltung von kritisch bewerteten Teilsystemen bereit, sodass der Betrieb der übrigen nicht kritisch eingestuften Teile der elektrischen Anlage ungehindert weitergeführt werden kann.

In weiterer Ausgestaltung erfolgt eine Abschaltung des Teilsystems, für das eine Unterschreitung des Teil-Isolationswiderstands-Grenzwertes oder eine Überschreitung des Teil-Netzableitkapazitäts-Grenzwertes festgestellt wird.

Wird/werden aufgrund eines unterschrittenen Teil-Isolationswiderstands-Grenzwertes oder eines überschrittenen Teil-Netzableitkapazität-Grenzwertes ein oder mehrere Teilsysteme als kritisch erkannt, so wird/werden die betreffenden Teilsystem(e) abgeschaltet. Alle weiteren Anlagenteile sind von dieser Teilsystem-selektiven Abschaltung nicht betroffen und können ihren Betrieb ungehindert fortsetzen.

Der Prüfstrom kann einen sinusförmigen Verlauf aufweisen, wobei das Bestimmen des ohmschen und des kapazitiven Teil-Prüfstromanteils in dem jeweiligen Teilsystem mittels einer Phasenauswertung des Teil-Prüfstroms erfolgt.

Alternativ kann der Prüfstrom einen rechteckförmigen Verlauf aufweisen, wobei das Bestimmen des ohmschen und des kapazitiven Teil-Prüfstromanteils in dem jeweiligen Teilsystem durch eine Auswertung von zeitlich aufeinanderfolgenden Signalabschnitten des Teil-Prüfstroms erfolgt, wobei Amplitudenverläufe von Einschwingvorgängen und von eingeschwungene Zuständen des Teil-Prüfstroms ausgewertet werden.

In Abhängigkeit der Signalform des erzeugten Prüfstroms werden unterschiedliche Verfahren zur Bestimmung des ohmschen und des kapazitiven Teil-Prüfstromanteils herangezogen.

Im Fall eines sinusförmigen Prüfstroms kann der erfasste Teil-Prüfstrom als komplexwertige Größe mit dem ohmschen Teil-Prüfstromanteil als Realteil und dem kapazitiven Teil-Prüfstromanteil als Imaginärteil aufgefasst werden. Der kapazitive Teil-Prüfstromanteil ergibt sich dabei als Funktion der Phasenverschiebung gegenüber dem eingespeisten Prüfstrom.

Im Fall eines rechteckförmigen Prüfstroms werden die Amplitudenverläufe zeitlich unmittelbar aufeinanderfolgende Signalabschnitte, d.h. von Einschwingvorgängen und daran anschließender eingeschwungener Zustände, des erfassten Teil-Prüfstroms ausgewertet.

Die Auswertung kann im Zeitbereich, oder, nach entsprechender Signaltransformation, in Frequenzebene erfolgen.

In Umsetzung des erfindungsgemäßen Verfahrens wird die Aufgabe weiterhin gelöst durch eine Überwachungsvorrichtung zur selektiven Bestimmung einer Teil-Netzableitkapazität in einem ungeerdeten Stromversorgungssystem, welches aus einem Hauptsystem und mindestens einem Teilsystem besteht, wobei die Überwachungsvorrichtung erfindungsgemäß umfasst: ein erweitertes Isolationsüberwachungssystem, welches zur Bestimmung eines Gesamt-Isolationswiderstands und einer Gesamt-Netzableitkapazität des Stromversorgungssystems ausgeführt ist, ein erweitertes Isolationsfehlersuchsystem, einen Prüfstrom-Generator zur kontinuierlichen Erzeugung und Einspeisung eines Prüfstroms in das Hauptsystem, mit Prüfstrom-Sensoren zur Erfassung eines Teil-Prüfstroms in jedem zu überwachenden Teilsystem und mit einem Isolationsfehler-Auswertegerät, an das die Prüfstrom-Sensoren angeschlossen sind, wobei das erweiterte Isolationsfehlersuchsystem ausgelegt ist zur Bestimmung eines ohmschen und eines kapazitiven Teil-Prüfstromanteils für jeden erfassten Teil-Prüfstrom und wobei die Überwachungsvorrichtung weiter ein Impedanz-Auswertesystem umfasst, das eine Impedanz-Auswerteeinheit zur Bestimmung eines Teil-Isolationswiderstands und einer Teil-Netzableitkapazität für jedes zu überwachende Teilsystem aus dem Gesamt-Isolationswiderstand, aus der Gesamt-Netzableitkapazität, aus dem Prüfstrom und aus den ohmschen und kapazitiven Teil-Prüfstromanteilen sowie eine Impedanz-Bewertungseinheit zur Bewertung des jeweils ermittelten Teil-Isolationswiderstands im Hinblick auf eine Unterschreitung eines Teil-Isolationswiderstands-Grenzwertes und zur Bewertung der jeweils ermittelten Teil-Netzableitkapazität im Hinblick auf eine Überschreitung eines Teil-Netzableitkapazitäts-Grenzwertes.

Die wesentlichen übergeordneten funktionalen Einheiten ("Systeme") der erfindungsgemäßen Überwachungsvorrichtung sind somit erstens ein erweitertes Isolationsüberwachungssystem, zweitens ein erweitertes Isolationsfehlersuchsystem mit einem Prüfstrom-Generator, mit Prüfstrom-Sensoren und mit einem Isolationsfehler-Auswertegerät sowie drittens ein Impedanz-Auswertesystem mit einer Impedanz-Auswerteeinheit und mit einer Impedanz-Bewertungseinheit.

Zur kontinuierlichen Erzeugung und Einspeisung eines Prüfstroms kann auch ein inhärent vorhandener Messstrom-Generator des erweiterten Isolationsüberwachungssystems genutzt werden. In diesem Fall ergänzt oder ersetzt der Messstrom-Generator des erweiterten Isolationsüberwachungssystems den Prüfstrom-Generator des erweiterten Isolationsfehlersuchsystems.

Das funktional erweiterte Isolationsüberwachungssystem unterscheidet sich von Isolationsüberwachungsgeräten herkömmlicher Bauart dadurch, dass es neben der üblichen Bestimmung des Gesamt-Isolationswiderstands zusätzlich für die Überwachung (Bestimmung) der Gesamt-Netzableitkapazität des ungeerdeten Stromversorgungssystems ausgeführt ist.

Der Prüfstrom-Generator des erweiterten Isolationsfehlersuchsystems oder der Messstrom-Generator des erweiterten Isolationsüberwachungssystems speist - im Gegensatz zu üblichen Isolationsfehlersuchsystemen, die nur nach einem aufgetretenen (ersten) Isolationsfehler aktiviert werden - kontinuierlich einen Prüfstrom in das ungeerdete Stromversorgungssystem ein. Das erweiterte Isolationsfehlersuchsystem ist im Vergleich zu den aus dem Stand der Technik bekannten Suchsystemen nicht nur zur betragsmäßigen Bestimmung des Teil-Prüfstroms ausgelegt, sondern ist in der Lage, aus dem erfassten Teil-Prüfstrom den ohmschen Teil-Prüfstromanteil und den kapazitiven Teil-Prüfstromanteil zu bestimmen.

Das Impedanz-Auswertesystem erfüllt in der Impedanz-Auswerteeinheit die Aufgabe, aus den von dem erweiterten Isolationsüberwachungssystem bereitgestellten Größen Gesamt-Isolationswiderstand und Gesamt-Netzableitkapazität und aus den von dem erweiterten Isolationsfehlersuchsystem bereitgestellten Größen Prüfstrom bzw. dessen Parameter sowie aus den ermittelten ohmschen und kapazitiven Teil-Prüfstromanteilen einen Teil-Isolationswiderstands und eine Teil-Netzableitkapazität für jedes zu überwachende Teilsystem zu bestimmen.

Der Impedanz-Bewertungseinheit des Impedanz-Auswertesystems obliegt schließlich die Aufgabe, den Teil-Isolationswiderstand und die Teil-Netzableitkapazität zu bewerten und im Fall einer Grenzwert-Unterschreitung oder -Überschreitung eine Alarmmeldung für das/die betreffende(n) Teilsysteme(e) auszugeben.

In weiterer Ausgestaltung weist die Überwachungsvorrichtung eine Steuer- und Abschaltvorrichtung auf, welche zur Abschaltung des Teilsystems ausgelegt ist, für das eine Unterschreitung des Teil-Isolationswiderstands-Grenzwertes oder eine Überschreitung des Teil-Netzableitkapazitäts-Grenzwertes festgestellt wird.

Falls durch die Impedanz-Bewertungseinheit ein Teilsystem aufgrund eines zu niedrigen Teil-Isolationswiderstands oder einer zu hohen Teil-Netzableitkapazität als kritisch bewertet wurde, so führt eine Steuer- und Abschaltvorrichtung die Abschaltung dieses Teilsystems - oder mehrerer als kritisch erkannte Teilsysteme - durch. Dabei werden verteilt in den Teilsystemen angeordnete Teilsystem-Abschaltvorrichtungen entsprechend den von der Impedanz-Bewertungseinheit erzeugten Alarmmeldungen angesteuert.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:
- **Fig. 1:**: ein ungeerdetes Stromversorgungssystem mit der erfindungsgemäßen Überwachungsvorrichtung,
- **Fig. 2:**: die Phasenauswertung eines Teil-Prüfstroms bei Einspeisung eines sinusförmigen Prüfstroms
- **Fig. 3:**: die Auswertung des zeitlichen Verlaufs eines Teil-Prüfstroms bei Einspeisung eines rechteckförmigen Prüfstroms und
- **Fig. 4:**: den prinzipiellen Verfahrensablauf in einem funktionalen Blockschaltbild der erfindungsgemäßen Überwachungsvorrichtung.

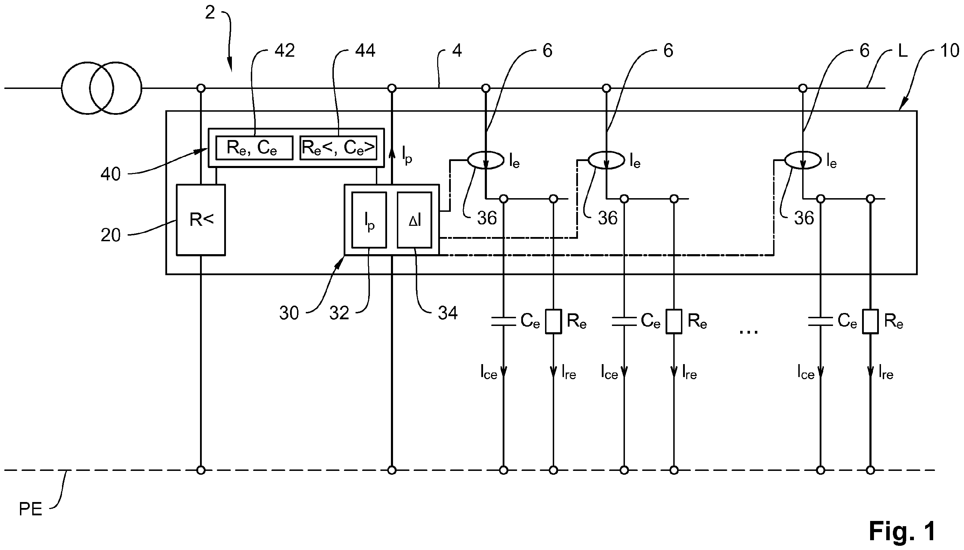

In **Fig. 1** ist ein ungeerdetes Stromversorgungssystem 2 mit einer erfindungsgemäßen Überwachungsvorrichtung 10 dargestellt. Das Stromversorgungssystem 2 besteht aus einem Hauptsystem 4 und n Teilsystemen 6. Die Teilsysteme 6 sind jeweils durch einen Teil-Isolationswiderstand Re und eine Teil-Netzableitkapazität Ce charakterisiert - die Ableit-Impedanz des Hauptsystems 4 ist in der vorliegenden Betrachtung vernachlässigt und die Teil-Isolationswiderstände Re bzw. die Teil-Netzableitkapazitäten Ce sind in der Praxis für die Teilsysteme 6 verschieden.

Die Überwachungsvorrichtung 10 umfasst als übergeordnete Funktionseinheiten ein erweitertes Isolationsüberwachungssystem 20, ein erweitertes Isolationsfehlersuchsystem 30 und ein Impedanz-Auswertesystem 40.

Das erweiterte Isolationsüberwachungssystem 20 ist zwischen mindestens einem aktiven Leiter L des Hauptsystems 4 und Erde PE geschaltet und überwacht einen Gesamt-Isolationswiderstand Reges des Stromversorgungssystems 2. Der Gesamt-Isolationswiderstand Reges ergibt sich aus der Parallelschaltung sämtlicher in dem Stromversorgungssystem vorhandenen Teil-Isolationswiderstände Re und entspricht dem Kehrwert der aufsummierten Teil-Isolationsleitwerte 1/Re. Als zusätzliche Funktion bestimmt das erweiterte Isolationsüberwachungssystem 20 eine Gesamt-Netzableitkapazität Ceges des Stromversorgungssystems 2. Diese Gesamt-Netzableitkapazität Ceges wird durch die Parallelschaltung sämtlicher Teil-Netzableitkapazitäten Ce gebildet und entspricht der Summe der Teil-Netzableitkapazitäten Ce.

Das erweiterte Isolationsfehlersuchsystem 30 umfasst einen Prüfstrom-Generator 32, der in gleicher Weise wie das erweiterte Isolationsüberwachungssystem 20 zwischen mindestens einem aktiven Leiter L des Hauptsystems 4 und Erde PE geschaltet ist und kontinuierlich einen Prüfstrom Ip in das Hauptsystem 4 einspeist. In dem dargestellten Ausführungsbeispiel ist der Prüfstrom-Generator 32 dem erweiterten Isolationsfehlersuchsystem 30 baulich zugeordnet. Zur kontinuierlichen Erzeugung und Einspeisung des Prüfstroms (Ip) kann aber auch ein Messstrom-Generator des erweiterten Isolationsüberwachungssystems 20 in Funktion des Prüfstrom-Generators 32 genutzt werden.

Dieser Prüfstrom Ip wird von in den Teilsystemen 6 angeordneten Prüfstrom-Sensoren 36 als Teil-Prüfstrom Ie erfasst, wobei die Größe des erfassten Teil-Prüfstroms Ie in dem jeweiligen Teilsystem 6 von dem Teil-Isolationswiderstand Re und der Teil-Netzableitkapazität Ce des jeweiligen Teilsystems 6 abhängt. Die Prüfstrom-Sensoren 36 sind zur Auswertung der Messsignale mit einem Isolationsfehler-Auswertegerät 34 des erweiterten Isolationsfehlersuchsystems 30 verbunden.

Der erfasste Teil-Prüfstrom Ie eines jeden Teilsystems 6 lässt sich in einen über den Teil-Isolationswiderstand Re fließenden ohmschen Teil-Prüfstromanteil Ire und einen über die Teil-Netzableitkapazität Ce fließenden kapazitiven Teil-Prüfstromanteil Ice aufteilen. Das erweiterte Isolationsfehlersuchsystem 30 ist daher so ausgeführt, dass neben dem der Bestimmung des ohmschen Teil-Prüfstromanteils Ire auch der kapazitive Teil-Prüfstromanteil Ice bestimmt werden kann.

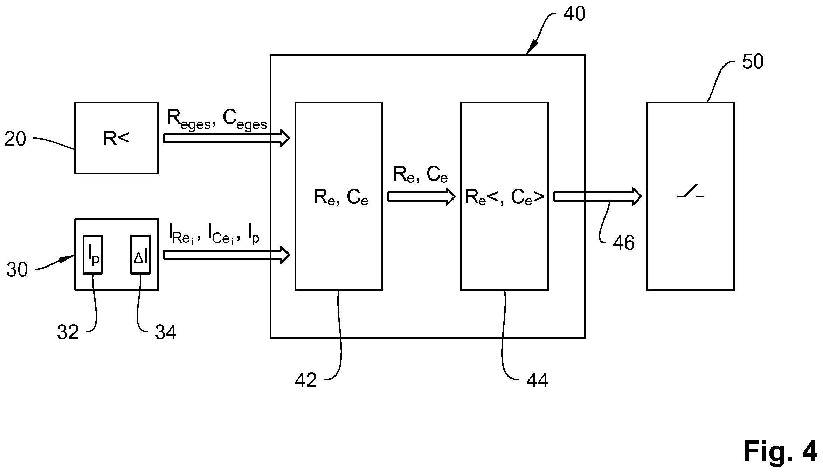

Das Impedanz-Auswertesystem 40 umfasst eine Impedanz-Auswerteeinheit 42 zur Bestimmung des Teil-Isolationswiderstands Re und der Teil-Netzableitkapazität Ce für jedes zu überwachende Teilsystem 6. Neben dem Prüfstrom Ip werden der von dem erweiterten Isolationsüberwachungssystem 20 ermittelte Gesamt-Isolationswiderstand Reges und die ermittelte Gesamt-Netzableitkapazität Ceges sowie der von dem erweiterten Isolationsfehlersuchsystem 30 ermittelte ohmsche Teil-Prüfstromanteil Ire und der kapazitive Teil-Prüfstromanteil Ice in die Berechnung des Teil-Isolationswiderstands Re und der Teil-Netzableitkapazität Ce mit einbezogen (siehe auch Fig. 4).

Weiterhin umfasst das Impedanz-Auswertesystem 40 eine Impedanz-Bewertungseinheit 44, in der die in der Impedanz-Auswerteeinheit 42 berechneten Größen Teil-Isolationswiderstands Re und Teil-Netzableitkapazität Ce für jedes zu überwachende Teilsystem 6 einer Bewertung im Hinblick auf die Unterschreitung (Re) oder Überschreitung (Ce) eines Grenzwertes unterzogen werden. Wird eine Unterschreitung oder eine Überschreitung festgestellt, so gilt dieser Zustand als kritisch und es erfolgt eine Alarmmeldung 46 (Fig. 4) für das betreffende Teilsystem 6.

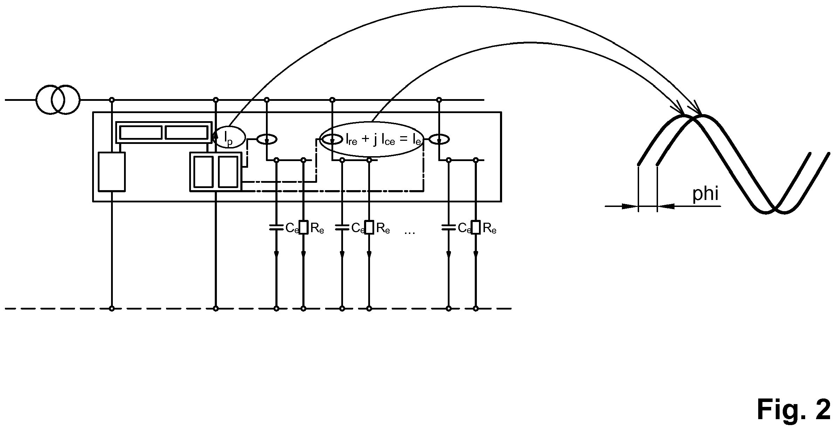

In **Fig. 2** zeigt die in dem erweiterten Isolationsfehlersuchsystem 30 ausgeführte Phasenauswertung eines erfassten Teil-Prüfstroms Ie zur Ermittlung des ohmschen und des kapazitiven Teil-Prüfstromanteils Ire, Ice bei Einspeisung eines sinusförmigen Prüfstroms Ip. Mit der Phasenlage des Prüfstroms Ip als Bezugsphase lässt sich die Größe des kapazitiven Teil-Prüfstromanteils Ice als Funktion des Phasenwinkels phi bestimmen.

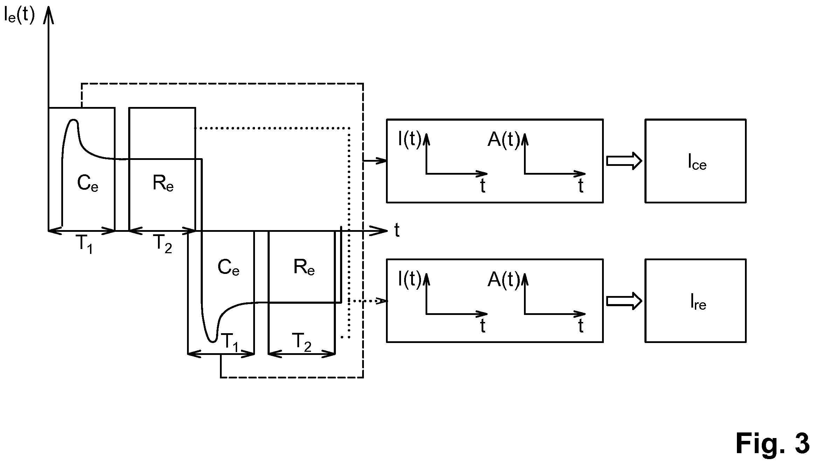

Die **Fig.3** zeigt die in dem erweiterten Isolationsfehlersuchsystem 30 ausgeführte Auswertung des zeitlichen Verlaufs eines erfassten Teil-Prüfstroms Ie zur Ermittlung des ohmschen und des kapazitiven Teil-Prüfstromanteils Ire, Ice bei Einspeisung eines rechteckförmigen Prüfstroms Ip. Der Amplitudenverlauf in einer Einschwingphase T1 des Teil-Prüfstroms Ie wird hinsichtlich der Parameter wie beispielsweise Anstiegszeit, Einstellzeit oder maximale Überschwingung analysiert und daraus auf die Größe des kapazitiven Teil-Prüfstromanteils Ice geschlossen. Um zufällige Störeinflüsse weitgehend zu eliminieren, werden dabei mehrere Einschwingvorgänge betrachtet.

In analoger Weise werden Amplitudenverläufe von eingeschwungenen Zuständen T2 ausgewertet, um nach Abklingen des kapazitiven Teil-Prüfstromanteils Ice den ohmschen Teil-Prüfstromanteil Ire bestimmen zu können.

In **Fig. 4** ist der prinzipielle Verfahrensablauf in einem funktionalen Blockschaltbild der erfindungsgemäßen Überwachungsvorrichtung 10 dargestellt.

Das erweiterte Isolationsüberwachungssystem 20 stellt den Gesamt-Isolationswiderstand Reges und die Gesamt-Netzableitkapazität Ceges bereit, das erweiterte Isolationsfehlersuchsystem 30 liefert den Prüfstrom Ip, den ohmschen Teil-Prüfstromanteil Ire und den kapazitiven Teil-Prüfstromanteil Ice. Aus diesen Größen berechnet die Auswerteeinheit 42 des Impedanz-Auswertesystems 40 den Teil-Isolationswiderstand Re und die Teil-Netzableitkapazität Ce für jedes zu überwachende Teilsystem 6. Die Bewertungseinheit 44 des Impedanz-Auswertesystems 40 bewertet den Teil-Isolationswiderstands Re und die Teil-Netzableitkapazität Ce daraufhin, ob ein kritischer Zustand aufgrund eines unterschrittenen Teil-Isolationswiderstands-Grenzwertes oder eines überschrittenen Teil-Netzableitkapazitäts-Grenzwertes vorliegt und gibt für das betreffenden Teilsystem 6 eine Alarmmeldung 46 aus.

Über eine optionale Steuer- und Abschaltvorrichtung 50 kann entsprechend der von der Bewertungseinheit 44 des Impedanz-Auswertesystems 40 erzeugten Alarmmeldung 46 das kritische Teilsystem 6 abgeschaltet werden.

## Patentansprüche

1. Verfahren zur selektiven Bestimmung einer Teil-Netzableitkapazität (Ce) in einem ungeerdeten Stromversorgungssystem (2), welches aus einem Hauptsystem (4) und mindestens einem Teilsystem (6) besteht, umfassend die Verfahrensschritte:
- Bestimmen eines Gesamt-Isolationswiderstands (Reges) des Stromversorgungssystems (2),
- Bestimmen einer Gesamt-Netzableitkapazität (Ceges) des Stromversorgungssystems (2),
- kontinuierliches Erzeugen und Einspeisen eines Prüfstroms (Ip) in das Hauptsystem (4),
- Erfassen eines Teil-Prüfstroms (Ie) in jedem zu überwachenden Teilsystem (6),
- Bestimmen eines ohmschen und eines kapazitiven Teil-Prüfstromanteils (Ire, Ice) für jeden erfassten Teil-Prüfstrom,
- Bestimmen eines Teil-Isolationswiderstands (Re) und einer Teil-Netzableitkapazität (Ce) für jedes zu überwachende Teilsystem (6) aus dem Gesamt-Isolationswiderstand (Reges), aus der Gesamt-Netzableitkapazität (Ceges), aus dem Prüfstrom (Ip) und aus den ohmschen und kapazitiven Teil-Prüfstromanteilen (Ire, Ice),
- Bewerten des jeweils ermittelten Teil-Isolationswiderstands (Re) im Hinblick auf eine Unterschreitung eines Teil-Isolationswiderstands-Grenzwertes und Bewerten der jeweils ermittelten Teil-Netzableitkapazität (Ce) im Hinblick auf eine Überschreitung eines Teil-Netzableitkapazitäts-Grenzwertes.

2. Verfahren nach Anspruch 1,
**dadurch gekennzeichnet,**
**dass** eine Abschaltung desjenigen Teilsystems (6) erfolgt, für das eine Unterschreitung des Teil-Isolationswiderstands-Grenzwertes oder eine Überschreitung des Teil-Netzableitkapazitäts-Grenzwertes festgestellt wird.

3. Verfahren nach Anspruch 1 oder 2,
**dadurch gekennzeichnet,**
**dass** der Prüfstrom (Ip) einen sinusförmigen Verlauf aufweist und das Bestimmen des ohmschen und des kapazitiven Teil-Prüfstromanteils (Ire, Ice) in dem jeweiligen Teilsystem (6) mittels einer Phasenauswertung des Teil-Prüfstroms (Ie) erfolgt.

4. Verfahren nach einem der Ansprüche 1 oder 2,
**dadurch gekennzeichnet,**
**dass** der Prüfstrom (Ip) einen rechteckförmigen Verlauf aufweist und das Bestimmen des ohmschen und des kapazitiven Teil-Prüfstromanteils (Ire, Ice) in dem jeweiligen Teilsystem (6) durch eine Auswertung von zeitlich aufeinanderfolgenden Signalabschnitten des Teil-Prüfstroms (Ie) erfolgt, wobei Amplitudenverläufe von Einschwingphasen (T1) und von eingeschwungene Zuständen (T2) des Teil-Prüfstroms (Ie) ausgewertet werden.

5. Überwachungsvorrichtung (10) zur selektiven Bestimmung einer Teil-Netzableitkapazität (Ce) in einem ungeerdeten Stromversorgungssystem (2), welches aus einem Hauptsystem (4) und mindestens einem Teilsystem (6) besteht,
aufweisend ,
ein erweitertes Isolationsüberwachungssystem (20), welches zur Bestimmung eines Gesamt-Isolationswiderstands (Reges) und einer Gesamt-Netzableitkapazität (Ceges) des Stromversorgungssystems (2) ausgeführt ist, ein erweitertes Isolationsfehlersuchsystem (30), einen Prüfstrom-Generator (32) zur kontinuierlichen Erzeugung und Einspeisung eines Prüfstroms (Ip) in das Hauptsystem (4), mit Prüfstrom-Sensoren (36) zur Erfassung eines Teil-Prüfstroms (Ie) in jedem zu überwachenden Teilsystem (6) und mit einem Isolationsfehler-Auswertegerät (34), an das die Prüfstrom-Sensoren (36) angeschlossen sind, wobei das erweiterte Isolationsfehlersuchsystem (30) ausgelegt ist zur Bestimmung eines ohmschen und eines kapazitiven Teil-Prüfstromanteils (Ire, Ice) für jeden erfassten Teil-Prüfstrom (Ie) und wobei die Überwachungsvorrichtung (10) weiter ein Impedanz-Auswertesystem (40) umfasst, das eine Impedanz-Auswerteeinheit (42) zur Bestimmung eines Teil-Isolationswiderstands (Re) und einer Teil-Netzableitkapazität (Ce) für jedes zu überwachende Teilsystem (6) aus dem Gesamt-Isolationswiderstand (Reges), aus der Gesamt-Netzableitkapazität (Ceges), aus dem Prüfstrom (Ip) und aus den ohmschen und kapazitiven Teil-Prüfstromanteilen (Ire, Ice) sowie eine Impedanz-Bewertungseinheit (44) zur Bewertung des jeweils ermittelten Teil-Isolationswiderstands (Re) im Hinblick auf eine Unterschreitung eines Teil-Isolationswiderstands-Grenzwertes und zur Bewertung der jeweils ermittelten Teil-Netzableitkapazität (Ce) im Hinblick auf eine Überschreitung eines Teil-Netzableitkapazitäts-Grenzwertes.

6. Überwachungsvorrichtung (10) nach Anspruch 5,
**gekennzeichnet durch**
eine Steuer- und Abschaltvorrichtung (50), welche zur Abschaltung des Teilsystems (6) ausgelegt ist, für das eine Unterschreitung des Teil-Isolationswiderstands-Grenzwertes oder eine Überschreitung des Teil-Netzableitkapazitäts-Grenzwertes festgestellt wird.

## Claims

1. A method for selectively determining a partial system leakage capacitance (Ce) in an ungrounded power supply system (2) which consists of a main system (4) and at least one partial system (6), comprising the method steps:
- determining an overall insulation resistance (Reges) of the power supply system (2),
- determining an overall system leakage capacitance (Ceges) of the power supply system (2),
- continuously generating and supplying a test current (Ip) to the main system (4),
- capturing a partial test current (Ie) in each partial system (6) to be monitored,
- determining an ohmic and a capacitive partial test-current portion (Ire, Ice) for each captured partial test current,
- determining a partial insulation resistance (Re) and a partial system leakage capacitance (Ce) for each partial system (6) to be monitored from the overall insulation resistance (Reges), from the overall system leakage capacitance (Ceges), from the test current (Ip) and from the ohmic and capacitive partial test-current portions (Ire, Ice),
- evaluating the respective identified partial insulation resistance (Re) in regard of the partial insulation resistance (Re) falling below a partial-insulation-resistance threshold, and evaluating the respective identified partial system leakage capacitance (Ce) in regard of the partial system leakage capacitance (Ce) exceeding a partial-system-leakage-capacitance threshold.

2. The method according to claim 1,
**characterized in that**
the respective partial system (6) is switched off, for which it has been confirmed that the partial insulation resistance (Re) has fallen below the partial-insulation-resistance threshold or for which it has been confirmed that the partial system leakage (Ce) has exceeded the partial-system-leakage capacitance threshold.

3. The method according to claim 1 or 2,
**characterized in that**
the test current (Ip) has a sine-shaped progress and **in that** the ohmic and the capacitive partial test-current portion (Ire, Ice) in the respective partial system (6) is determined by means of evaluating the phase of the partial test current (Ie).

4. The method according to any one of the claims 1 or 2,
**characterized in that**
the test current (Ip) has a square-wave progress and **in that** the ohmic and the capacitive partial test-current portion (Ire, Ice) in the respective partial system (6) is determined by evaluating temporally consecutive signal sections of the partial test current (Ie), amplitude progresses of settling times (T1) and of settled states (T2) of the partial test current (Ie) being evaluated.

5. A monitoring device (10) for selectively determining a partial system leakage capacitance (Ce) in an ungrounded power supply system (2) which consists of a main system (4) and at least one partial system (6),
comprising
an extended insulation monitoring system (20) which is configured for determining an overall insulation resistance (Reges) and an overall system leakage capacitance (Ceges) of the power supply system (2); an extended insulation fault location system (30); a test-current generator (32) for continuously generating and feeding a test current (Ip) into the main system (4), having test-current sensors (36) for capturing a partial test current (Ie) in each partial system (6) to be monitored and having an insulation-fault evaluation device (34) to which the test-current sensors (36) are connected; said extended insulation fault location system (30) being configured for determining an ohmic and a capacitive partial test-current portion (Ire, Ice) for each captured partial test current (Ie) and said monitoring device (10) further comprising an impedance evaluation system (40) which comprises an impedance evaluation unit (42) for determining a partial insulation resistance (Re) and a partial system leakage capacitance (Ce) for each partial system (6) to be monitored from the overall insulation resistance (Reges), from the overall system leakage capacitance (Ceges), from the test current (Ip) and from the ohmic and capacitive partial test-current portions (Ire, Ice) as well as comprising an impedance assessment unit (44) for assessing the respective identified partial insulation resistance (Re) in regard of the partial insulation resistance falling below a partial insulation-resistance threshold and for assessing the respective identified partial system leakage capacitance (Ce) in regard of the identified partial system leakage capacitance exceeding a partial system-leakage-capacitance threshold.

6. The monitoring device (10) according to claim 5,
**characterized by**
a controlling and switching-off device (50) which is configured for switching off the partial system (6) for which it has been confirmed that the partial insulation resistance has fallen below the partial insulation-resistance threshold or that the partial system leakage capacitance has exceeded the partial system-leakage-capacitance threshold.

## Revendications

1. Procédé pour la détermination sélective d'une capacité (Ce) de fuite de réseau partielle dans un système (2) d'alimentation en énergie sans prise de terre, le système (2) d'alimentation en énergie sans prise de terre se composant d'un système (4) principal et d'au moins un sous-système (6), comprenant les étapes de procédé suivantes :
- détermination d'une résistance (Reges) d'isolement totale du système (2) d'alimentation en énergie,
- détermination d'une capacité (Ceges) de fuite de réseau totale du système (2) d'alimentation en énergie,
- génération continue d'un courant (Ip) de test et alimentation continue en courant (Ip) de test système (4) principal,
- saisie d'un courant (Ie) de test partiel dans chaque sous-système (6) à surveiller,
- détermination d'une part ohmique et d'une part capacitive (Ire, Ice) du courant de test partiel pour chaque courant de test partiel saisi,
- détermination d'une résistance (Re) d'isolement partielle et d'une capacité (Ce) de fuite de réseau partielle pour chaque sous-système (6) à surveiller de la résistance (Reges) d'isolement totale, de la capacité (Ceges) de fuite de réseau totale, du courant (Ip) de test et des parts (Ire, Ice) ohmique et capacitive du courant de test partiel,
- évaluation de la résistance (Re) d'isolement partielle identifiée respective au regard d'une descente en-deçà d'un seuil de résistance d'isolement partielle, et évaluation de la capacité (Ce) de fuite de réseau partielle identifiée respective au regard d'un dépassement d'un seuil de capacité de fuite de réseau partielle.

2. Procédé selon la revendication 1,
**caractérisé en ce que**
le sous-système (6) pour lequel une descente en-deçà du seuil de résistance d'isolement partielle est décelée ou pour lequel un dépassement du seuil de capacité de fuite de réseau partielle est décelé est déconnecté.

3. Procédé selon la revendication 1 ou 2,
**caractérisé en ce que**
le courant (Ip) de test a une courbe sinusoïdale et **en ce que** les parts ohmique et capacitive (Ire, Ice) du courant de test partiel sont déterminées dans le sous-système (6) respectif au moyen d'une évaluation de phase du courant (Ie) de test partiel.

4. Procédé selon l'une quelconque des revendications 1 ou 2,
**caractérisé en ce que**
le courant (Ip) de test a une courbe carrée et **en ce que** les parts ohmique et capacitive (Ire, Ice) du courant de test partiel sont déterminées dans le sous-système (6) respectif par une évaluation de sections de signal de suite du courant (Ie) de test partiel, des courbes d'amplitude d'états (T1) transitoires et d'états (T2) stationnaires du courant (Ie) de test partiel étant évaluées.

5. Dispositif (10) de surveillance pour la détermination sélective d'une capacité (Ce) de fuite de réseau partielle dans un système (2) d'alimentation en énergie sans prise de terre, le système (2) d'alimentation en énergie sans prise de terre se composant d'un système (4) principal et d'au moins un sous-système (6), comprenant
un système (20) de surveillance d'isolement étendu qui est configuré pour la détermination d'une résistance (Reges) d'isolement totale et d'une capacité (Ceges) de fuite de réseau totale du système (2) d'alimentation en énergie, un système (30) de location de défaut d'isolement étendu, un générateur (32) de courant de test pour la génération continue d'un courant (Ip) de test et l'alimentation continue en courant (Ip) de test du système (4) principal, ayant des capteurs (36) de courant de test pour la saisie d'un courant (Ie) de test partiel dans chaque sous-système (6) à surveiller et ayant un dispositif (34) d'évaluation de défaut d'isolement auquel les capteurs (36) de courant de test sont reliés, le système (30) de location de défaut d'isolement étendu étant configuré pour la détermination d'une part ohmique et d'une part capacitive (Ire, Ice) du courant de test partiel pour chaque courant (Ie) de test partiel saisi et le dispositif (10) de surveillance comprenant en outre un système (40) d'évaluation d'impédance qui comprend une unité (42) d'évaluation d'impédance pour la détermination d'une résistance (Re) d'isolement partielle et d'une capacité (Ce) de fuite de réseau partielle pour chaque sous-système (6) à surveiller de la résistance (Reges) d'isolement totale, de la capacité (Ceges) de fuite de réseau totale, du courant (Ip) de test et des parts ohmique et capacitive (Ire, Ice) du courant de test partiel et comprend une unité (44) d'évaluation d'impédance pour l'évaluation de la résistance (Re) d'isolement partielle identifiée respective au regard d'une descente en-deçà d'un seuil de résistance d'isolement partielle et pour l'évaluation de la capacité (Ce) de fuite de réseau partielle identifiée respective au regard d'un dépassement d'un seuil de capacité de fuite de réseau partielle.

6. Dispositif (10) de surveillance selon la revendication 5,
**caractérisé par**
un dispositif (50) de contrôle et de déconnexion qui est configuré pour déconnecter le sous-système (6) pour lequel une descente en-deçà du seuil de résistance d'isolement partielle est décelée ou pour lequel un dépassement du seuil de capacité de fuite de réseau partielle est décelé.
